Europäisches Patentamt

(19) European Patent Office

Office européen des brevets

(11) Publication number: **0 248 292**
B1

# (12) EUROPEAN PATENT SPECIFICATION

(45) Date of publication of the patent specification:
21.03.90

(21) Application number: **87107487.8**

(22) Date of filing: **22.05.87**

(51) Int. Cl.⁴: **H01L 29/78**, H01L 29/10,
H01L 29/08

(54) Semiconductor device having a high breakdown voltage.

(30) Priority: 23.05.86  JP 118506/86

(43) Date of publication of application:
09.12.87 Bulletin 87/50

(45) Publication of the grant of the patent:
21.03.90 Bulletin 90/12

(84) Designated Contracting States:
DE FR GB

(56) References cited:
EP-A- 0 033 003
US-A- 4 172 260

IEEE INTERNATIONAL ELECTRON DEVICES MEETING,
San Francisco, CA, 13th-15th December 1982,
pages 254-257, IEEE; H. SAKUMA et al.: "Parasitic
effect-free, high voltage MOS ICs with shielded source
structure"
PATENT ABSTRACTS OF JAPAN, vol. 9,
no. 274 (E-354)[1997], 31st October 1985 &
JP-A-60 117 674

(73) Proprietor: FUJITSU LIMITED, 1015, Kamikodanaka
Nakahara-ku, Kawasaki-shi Kanagawa 211(JP)

(72) Inventor: Shirato, Takehide Fujitsu Limited, Kosugi
Fujitsu Building 1812-10 Shimonumabe, Nakahara-ku
Kawasaki-shi Kanagawa 211(JP)

(74) Representative: Sunderland, James Harry et al,
HASELTINE LAKE & CO Hazlitt House 28 Southampton
Buildings Chancery Lane, London WC2A 1AT(GB)

ACTORUM AG

## Description

The present invention relates to a semiconductor device having a high breakdown voltage.

Recently, an IC device including a control circuit for controlling a high voltage driving device such as a display device has found wide use. In the IC device, characteristics relating to breakdown voltage, power driving ability, operation speed and amplification factor are required to be high in response to advantages of the high voltage driving device, such as large scale integration, complex function and high speed.

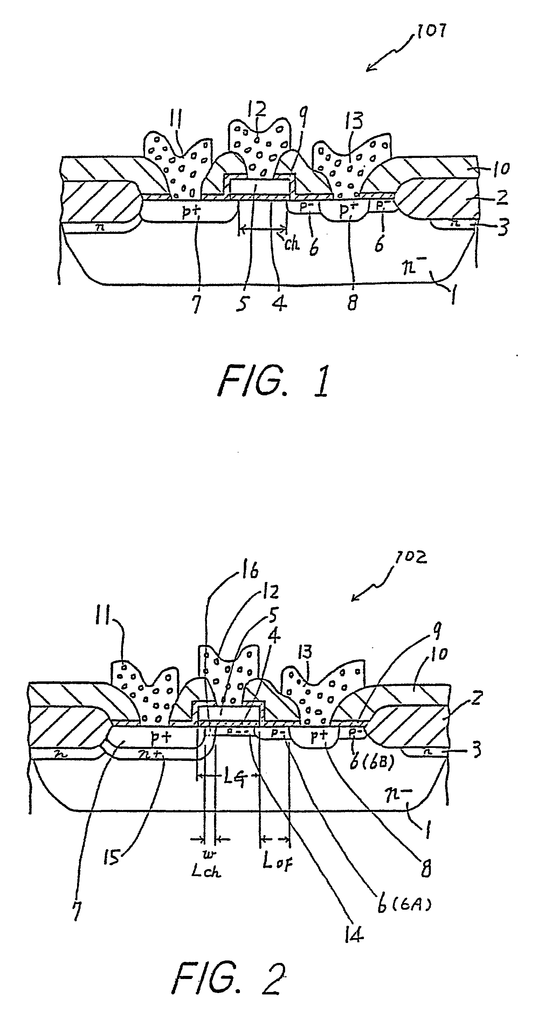

Fig. 1 is a schematic sectional side view illustrating the structure of an enhancement type MIS transistor 101 as an example of a previous semiconductor device having a high breakdown voltage characteristic. A device similar to that of Fig. 1 is disclosed in JP-A 60 117 674 (see Patent Abstracts of Japan, Vol. 9, No. 274 [E-354], 1997).

In Fig. 1, the MIS transistor 101 basically comprises a $p^+$ type source region 7, a $p^+$ type drain region 8 and a gate electrode 5. The source region 7 and the drain region 8 are formed on the surface of an $n^-$ type well 1, and the gate electrode 5 is formed above the surface of the well 1 with the interposition of a gate oxide layer 4. When a gate voltage is applied to the gate electrode 5, a channel region ch is formed under the gate electrode 5. 3 is an n type channel stopper. A field oxide layer 2 is provided for separating a transistor region of the MIS transistor 101 from other electrical elements which are not shown in Fig. 1. An impurity block oxide layer 9 is formed on the source region 7, the drain region 8 and the gate electrode 5, and then an insulating film 10 is formed on the impurity block oxide layer 9 and the field oxide layer 2. The insulating film 10 is for insulating source wiring 11, gate wiring 12 and drain wiring 13 respectively.

The wirings 11, 12 and 13 are connected with the source region 7, the gate electrode 5 and the drain region 8 respectively, removing parts, which correspond to respective wirings, of the impurity block oxide layer 9 and the insulating film 10. Region 6, located between the channel region ch and the drain region 8, is a $p^-$ type offset region having a low impurity concentration compared with impurity concentration of the drain region 8, for obtaining high resistance As a result of the provision of the offset region 6, a depletion layer produced around the drain region 8 can be expanded, which results in an increase of breakdown voltage at the drain region 8 to a high level.

However, the illustrated MIS transistor 101 has the following problems.

(1) Area occupied by the MIS transistor 101 tends to be enlarged because an offset length $L_{OF}$ of the offset region 6, located between the channel region ch and the drain region 8, is required to be increased in order to obtain a high breakdown voltage at the drain region 8.

(2) Operation speed and amplication factor ($\beta$) of the MIS transistor 101 decrease because the offset length $L_{OF}$ is increased, with increasing resistance thereof. The amplification factor $\beta$ is defined by the following formula:

$$\beta = W/L . \mu \ e_{ox}/t_{ox} \text{ where,}$$

$\beta$: amplification factor,
W: channel width,
L: channel length,
$\mu$: mobility of carriers flowing through the channel,
$e_{ox}$: dielectric constant of the channel, and
$t_{ox}$: thickness of the gate oxide layer.

In the above formula, when the offset length $L_{OF}$ is increased, the mobility $\mu$ decreases, which results in a decrease of the amplification factor $\beta$.

(3) The width of the offset region 6 must be increased in order to provide high power, because the conductance of the offset region 6 would be decreased if only the length $L_{OF}$ were increased. This increase in width results in an enlargement of the area occupied by the MIS transistor 101.

(4) The channel length of the channel region ch is determined by the length of the gate electrode, so that the minimum channel length is limited by the minimum length of the gate electrode. The minimum length of the gate electrode is limited by the technical limitations of photo lithography. Therefore, the channel length has a minimum length limitation so long as the gate electrode is formed using photo lithography. In other words, operation speed and amplification factor $\beta$ are limited by the minimum length of gate electrode which can be provided, as long as the gate electrode is formed by applying photo lithography; and

(5) Generally, MIS transistors appear in two types: an enhancement type and depletion type, and for an amplifier such as the MIS transistor disclosed here, an enhancement type MIS transistor is used. Thus, the MIS transistor 101 is an enhancement type and moreover it has the long channel indicated above, so that ON resistance of the MIS transistor 101 is high. Therefore, it is hard to obtain high power operation and a high amplification factor $\beta$ of the MIS transistor 101.

IEEE International Electron Devices Meeting 1982 (IEDM-82) Technical Digest, pages 254 to 257, in an article by Sakuma et al, discloses an offset gate MOS transistor comprising:

a semiconductor body having a first regioin (p) containing a first concentration of impurities of a first type;

a gate electrode formed to extend over the first region;

a source region (n+), formed in the body adjacent to the first region, containing a second concentration of impurities of a second type, opposite to the first type;

a drain region (n+), formed in the body, containing impurities of the second conductivity type to the second concentration, the drain region being formed opposite to the source region with regard to the gate electrode so that a side edge of the drain region, facing the source region, is separated by a first space from the first region; and

an offset region (n-) formed adjacent to the drain region to occupy the first space, the first offset region containing impurities of the second conductivity type to a third concentration, lower than the second concentration.

The offset region (n⁻) extends under the gate electrode with a side edge of the offset region, facing the source region, being separated by a second space from the present invention there is provided a metal insulator semiconductor device having a high breakdown voltage characteristic, comprising:

a semiconductor body having a first region containing a first concentration of impurities of a first type;

a gate electrode formed to extend over the first region;

a source region, formed in the body adjacent to the first region, containing a second concentration of impurities of a second type, opposite to the first type;

a drain region, formed in the body, containing impurities of the second conductivity type to the second concentration, the drain region being formed opposite to the source region with regard to the gate electrode so that a side edge of the drain region, facing the source region, is separated by a first space from the first region; and

a first offset region formed adjacent to the drain region to occupy the first space, the first offset region containing impurities of the second conductivity type to a third concentration, lower than the second concentration;

characterised by at least one depletion region, formed in the first region β so as to be adjacent to the first offset region, the depletion region containing impurities of the second conductivity type to a fourth impurity concentration, lower than the third impurity concentration, and a side edge of the depletion region, facing the source region, being positioned so as to be separated by a second space from the source region; and

an enhancement type channel region formed in said first region so as to fill up said second space, said channel region containing impurities of the first conductivity type to a fifth impurity concentration, higher than said first impurity concentration.

An embodiment of the present invention can provide for an increased breakdown voltage characteristic.

An embodiment of the present invention can provide for a decrease in area occupied by the semiconductor device, even though breakdown voltage is increased.

An embodiment of the present invention can provide for an increase in operation speed of the semiconductor device.

An embodiment of the present invention can provide for an improved power ability of the semiconductor device.

An embodiment of the present invention provides a Metal Insulator Semiconductor (MIS) transistor having a structure such that a high breakdown voltage characteristic can be obtained without reducing the packing density of a semiconductor integrated circuit (IC) device in which such MIS transistors are employed, and such that an increased amplification factor can be attained.

In an embodiment of the present invention a depletion region and an enhancement type channel region are formed in a surface part of a semiconductor substrate of a semiconductor device (MIS transistor) under a gate electrode of the MIS transistor, in a direction from a drain region to a source region of the MIS transistor. The depletion region is defined hereinafter as a region having a low impurity concentration of impurities of a type (a second type) opposite to the type (a first type) of impurities doped in the semiconductor substrate, compared with the impurity concentration of impurities of the second type in the drain region. Note that the depletion region differs from a depletion layer. The depletion region is formed adjacent to an offset region formed around the drain region, which offset region has a lower impurity concentration than that of the drain region for increasing the breakdown voltage at the drain region as indicated in the explanation given with reference to Fig. 1. As the depletion region is formed by doping with second type impurities to a low impurity concentration, the resistance of the depletion region is extremely high when a gate voltage is not applied to the gate electrode. Therefore, an electrical potential at an end contacted with the enhancement channel region decreases, which results in the provision of a breakdown voltage for the drain region higher than that of the device illustrated in Fig. 1. When gate voltage is applied to the gate electrode, the resistance, equal to ON resistance of the MIS transistor, of the depletion region decreases, so that driving current of the MIS transistor and the amplification factor β increase. The impurities doped in the depletion region are of the same type as in the offset region. However, the impurity concentration of the depletion region is lower than that of the offset region. Therefore, the resistance of the depletion region is higher than that of the offset region when the gate voltage is not applied to the gate electrode, so that a depletion layer produced around the depletion region increases, resulting in a further increase of breakdown voltage at the drain region. Because the introduction of the depletion region, a high breakdown voltage characteristic can be obtained for an MIS transistor without enlarging the size of the MIS transistor.

An enhancement type channel region is formed between a source region and the depletion region; the source region being formed by doping with second type impurities to the same impurity concentration as the drain region, being aligned with the gate electrode, and being opposite to the drain region, being aligned with the gate electrode, and being opposite to the drain region with regard to the gate electrode. The enhancement type channel region is formed by doping with first type impurities to an impurity concentration higher than that of the semiconductor substrate, and the enhancement type channel region is formed to have an extremely short channel length, so that a high operation speed can be obtained.

According to the present invention there is provided a method for fabricating a metal insulator semiconductor device having a high breakdown voltage characteristic comprising the steps of:

providing a first semiconductor substrate region containing a first impurity concentration of impurities of a first type;

forming a fourth region containing impurities of a second type, opposite to the first type, to a fourth impurity concentration, in the first region;

forming a gate electrode to extend over the fourth region;

forming a fifth region, with impurities of the first type to a fifth impurity concentration, in the first region, adjacent to one side of the gate electrode, by doping first type impurities into the fourth region in alignment with the gate electrode, the fifth impurity concentration being higher than said first impurity concentration;

inverting the conductivity type of a part of the fourth region neighbouring the fifth region and under the gate electrode, so as to have the fifth impurity concentration, by laterally diffusing the fifth region so that the fifth region extends laterally by a second length, in direction from the said one side of the gate electrode to the opposite side of the gate electrode;

forming a third region, having a third impurity concentration of impurities of the second type, in the first region adjacent to the said opposite side of the gate electrode, by doping impurities of the second type into the fourth region, in alignment with the gate electrode, the third impurity concentration being higher than the fourth impurity concentration; and

forming two second regions, to provide a source region and a drain region respectively, having a second impurity concentration of impurities of the second type by doping impurities of the second type into the fifth region, in alignment with the gate electrode, to form the source region, and doping impurities of the second type into the third region to form the drain region, the second impurity concentration being higher than the third impurity concentration, the source region being formed on the said one side of said gate electrode and the drain region being formed on the said opposite side of the gate electrode spaced apart from the gate electrode, an edge, facing the drain region, of the gate electrode and an edge, facing the gate electrode, of the drain region being spaced apart.

In accordance with this method an extremely short channel length is provided in the following way: first, first type impurities are doped into a region (the fifth region) where the source region will be formed in a later step, in alignment with the gate electrode; second, the doped-in first type impurities are laterally diffused until the first type impurity region arrives under the gate electrode, by applying, for example a drive-in heat treatment; third, second type impurities are doped into the first type impurity region, in alignment with the gate electrode; and fourth, the doped-in second type impurities are laterally diffused for forming the source region. As a result of the above steps, which are called a diffusion self-aligning (DSA) process, an extremely short first impurity type region, which becomes the enhancement type channel region, is produced; that is, an extremely short part, which is left after lateral diffusion of the second type impurities, of the first type impurity region becomes the extremely short channel length of the enhancement type channel region. Applying thus the DSA method, an enhancement type channel region having the extremely short channel length can be formed easily, precisely, at low cost, and with excellent reproducibility.

Reference is made, by way of example, to the accompanying drawings, in which:

Fig. 1 is a schematic sectional side view of a previous MIS transistor having a high breakdown voltage characteristic;

Fig. 2 is a schematic sectional side view of a semiconductor device having a high breakdown voltage characteristic and embodying the present invention;

Fig. 3 is a graph illustrating impurity concentration profile of regions (from a source region to a drain region) of the semiconductor device of Fig. 2, embodying the present invention;

Figs. 4(a), 4(b), 4(c), 4(d), 4(e) and 4(f) are schematic sectional side views illustrating steps for fabricating a semiconductor device embodying the present invention; and

Fig. 5 is a schematic sectional side view of another semiconductor device having a high breakdown characteristic and embodying the present invention.

In Figs. 2 to 5, the same reference signs indicate the same or similar items.

In Fig. 2, a MIS transistor 102 is illustrated as a semiconductor device having a high breakdown voltage characteristic and embodying the present invention. The MIS transistor 102 basically comprises a $p^+$ type source region 7 having an impurity concentration of $10^{20} cm^{-3}$, a $p^+$ type drain region 8 having the same impurity concentration as that of the source region 7, and a gate electrode 5 comprising, for example, polycrystalline silicon having a gate length $L_G$ of, for example, 5 μm. The source region 7 and the drain region 8 are formed in the surface part of an $n^-$ type well 1, and the gate electrode 5 is formed above the surface of the well 1 with the interposition of a gate oxide layer 4. 3 is an n type channel stopper. Particularly, the channel stopper 3 at the side of the drain region 8 is separately formed from the drain region 8 for preventing the occurrence of a fall of breakdown voltage at the drain region 8. A field oxide layer 2 is provided for separating a transistor region for the MIS transistor 101 from other electrical elements which are not shown in Fig. 2. An impurity block oxide layer 9 is formed on the source region 7, the drain region 8 and the gate electrode 5. The insulating film 10 comprises phosphoric silicon glass (PSG) and is formed on the impurity block oxide layer 9 and the field oxide layer 2 for insulating source wiring 11, gate wiring 12 and drain wiring 13 from each other. The wirings 11, 12 and 13 comprise aluminum (Al) and are connected with the source region 7, the gate electrode 5 and the drain region 8 respectively. Region 6 located around the drain region 8 is a $p^-$ type offset region having an impurity concentration of $10^{17} cm^{-3}$, for obtaining high resistance. The offset region 6 is provided for expanding a depletion layer for the drain region 8, which results in an increase of the breakdown voltage at the drain region 8. The offset region 6 is divided into 6A and 6B; wherein offset region 6A is a region located between a P$^{--}$ type depletion region 14, which will be explained later, and the drain region 8, and offset region 6B is a region located between the drain region 8 and the field oxide layer 2 located at the side of the drain region 8. Particularly, a length $L_{OF}$ of the offset region 6A is quite effective for obtaining a high breakdown voltage at the drain region 8 as mentioned in the explanation of the previous device of Fig. 1. The length $L_{OF}$ is approximately 3 μm in this embodiment.

In this embodiment of the present invention, the structure described above is in many ways similar to that of the previous device explained with reference to Fig. 1. However, regions of 14, 15 and 16 provide a structure different from that of the previous device. That is, in the previous device there is no particular region, in which purities are doped, in the surface part of the well 1, under the gate electrode 5; only the channel region ch is produced as shown in Fig. 1 when a proper gate voltage is applied to the gate electrode 5. However, in this embodiment of the present invention, regions 14 and 16, in which different type impurities are doped respectively, are formed in place of the channel forming region ch of the previous device. The region 14 is a p$^{--}$ type depletion region having an impurity concentration of $10^{16}$ cm$^{-3}$, the region 16 is an enhancement type channel region having a very short channel length $L_{ch}$ such as 0.2 to 0.5 μm, and the region 15 is an n$^{+}$ type region having an impurity concentration of $10^{17}$ to $10^{19}$ cm$^{-3}$. Wherein, the region 15 is secondarily formed for providing the region 16.

The n$^{+}$ type region 15 is formed by (1) doping impurities into a surface part of the well 1, aligned with the side edges of the field oxide layer 2 and the gate electrode 5 at a place where the source region 7 is subsequently to be formed, before forming the source region 7, and (2) laterally diffusing the doped impurities by carrying out a drive-in heat treatment so that a designated width w, which corresponds to channel length $L_{ch}$, of the p$^{--}$ type depletion region 14 is inverted to form n$^{+}$ type enhancement type channel region 16.

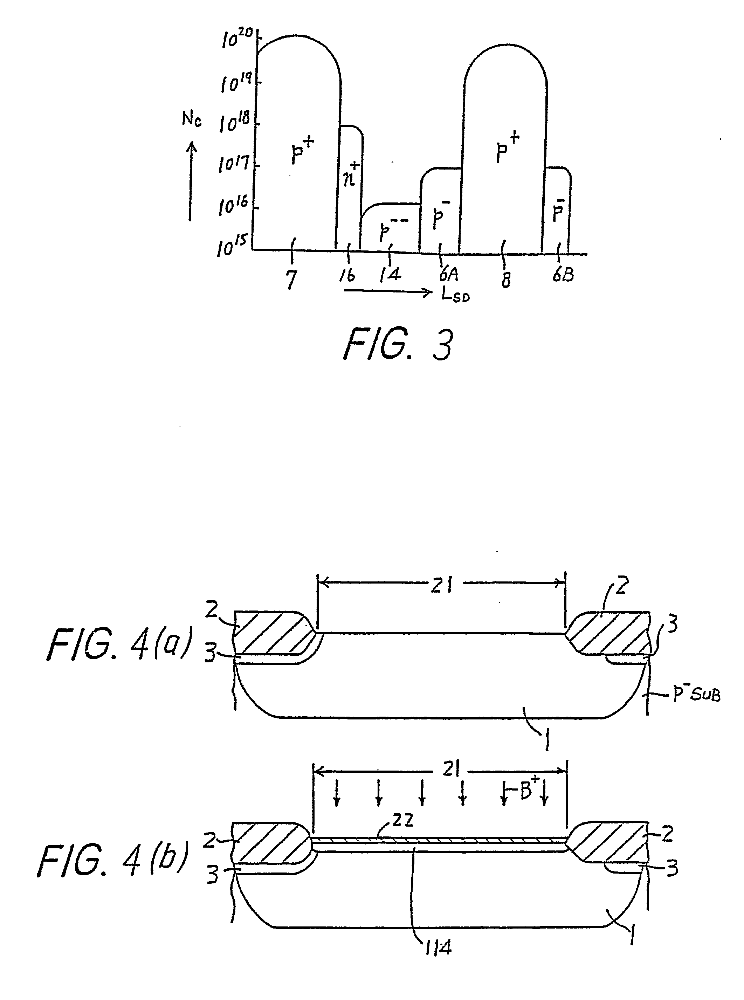

Fig. 3 illustrates impurity concentration profile between source region 7 and the drain region 8 of the above-described embodiment of the present invention. In Fig. 3, $N_C$ indicates impurity concentration and $L_{SD}$ indicates distance towards drain region 8 from source region 7. As shown in Fig. 3, impurity concentration in the offset region 6 and the depletion region 14 is decreased in a direction from the drain region 8 towards the enhancement type channel region 16, which results in an increased breakdown voltage at the drain region 8 when gate voltage is not applied to the gate electrode 5, as explained above. Therefore, there is no need to enlarge the offset region 6, in other words, the size of the MIS transistor need not be increased in order to increase the breakdown voltage characteristic. When gate voltage is applied to the gate electrode 5, since the resistance of the depletion region 14 is decreased because of the doped p$^{--}$ type impurities and because the channel length $L_{ch}$ is extremely short, the power ability and the amplification factor β of the MIS transistor increase as explained above.

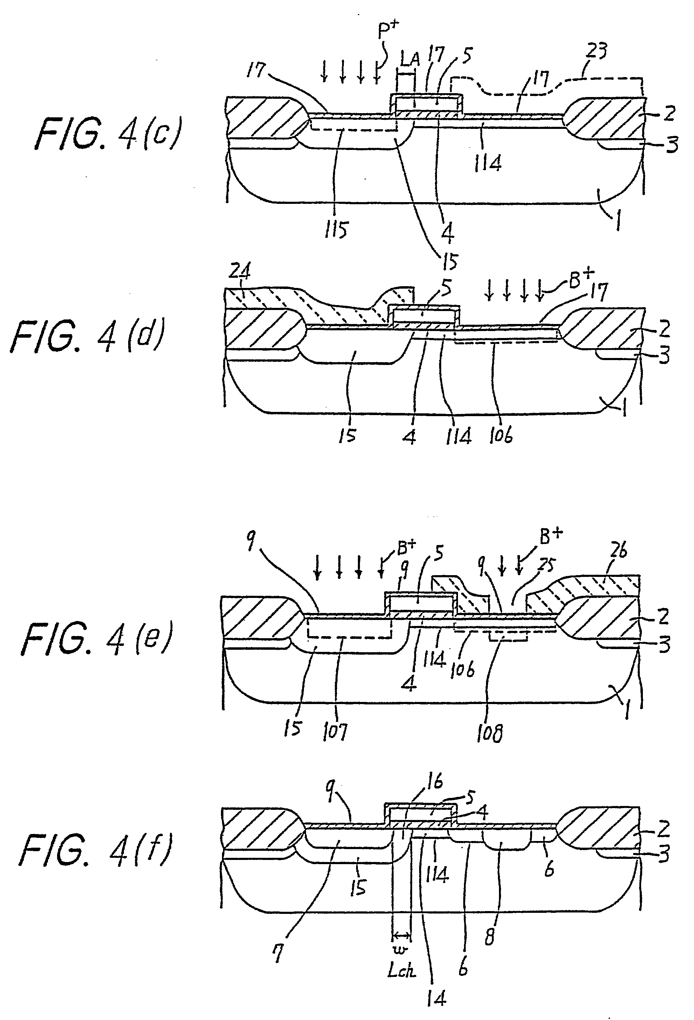

An embodiment of the present invention will be further detailed by disclosing a method of fabricating a metal oxide semiconductor (MOS) transistor, as follows referring to Figs. 4(a) to 4(f).

(1) Referring to Fig. 4(a): A p$^{-}$ type silicon substrate, indicated by symbol p$^{-}$ SUB in Fig. 4(a), having a resistivity of several tens of ohm-cm, is provided and n type impurities are selectively doped into a surface part thereof. In the surface part of the substrate, an n$^{-}$type well 1 having an impurity concentration of $10^{15}$ cm$^{-3}$ is formed; a field oxide layer 2 for defining a transistor element forming region 21 is formed by applying a selective oxidation technique; and an n type channel stopper 3 is formed beneath the field oxide layer 2 by applying an ion implantation technique. As explained above, channel stopper 3 at the side of the (subsequently to be formed) drain region 8 is separated from an edge of the transistor element forming region 21 for avoiding reduction of breakdown voltage at the drain region 8.

(2) Referring to Fig. 4(b): After forming a protection layer 22 on the surface of the well 1 over the region 21, a p$^{--}$ type inversion region 114 having an impurity concentration of $10^{16}$ cm$^{-3}$ is formed in the surface part of the well 1 beneath the protection layer 22. The protection layer 22 is formed by applying a heat oxidation method, providing an annealing treatment, and by executing ion implantation of boron (B$^{+}$) into the surface part of the well 1 beneath the protection layer 22 through the protection layer 22 the region 114 is formed.

(3) Referring to Fig. 4(c): After removing the protection layer 22, a gate oxide layer 4 is formed over the transistor element forming region 21, an electrically conductive layer, for example of polycrystalline silicon, is formed thereover, and then a gate electrode composed of, for example, polycrystalline silicon is formed on the gate oxide layer 4 by applying photo lithography. Next, after removing parts of the layer 4 not under the gate electrode, by etching using the gate electrode 5 as a mask, a thin oxide film 17 is formed. Next, masking a drain forming region, which is a region in which a drain region is to be formed, with a first resist mask 23, ion implantation is carried out into a source forming region using a proper dose of, for example, phosphorus (P$^{+}$) as donor, in alignment with the gate electrode 5 (115 is a P$^{+}$ implantation region). Then, after removing the first resist mask 23, an n$^{+}$ type region 15 having an impurity concentration of $10^{18}$ cm$^{-3}$ is formed to a depth of 8,000 Angstroms (800 nm). Part of the p$^{--}$ type region 114 is inverted by the drive-in heat treatment. Namely, the phosphorus also diffuses in a lateral direction, so that the n$^{+}$ type region 15 is formed partly beneath the gate electrode, extending approximately 8,000 Angstroms (800 nm) laterally beneath the gate electrode as shown by reference symbol $L_A$ in Fig. 4(c). The impurity concentration of the region 15 can be adjusted to provide a proper threshold voltage ($V_{th}$) for the MOS transistor.

(4) Referring to Fig. 4(d): Masking a source forming region by using a resist mask 24, ion implantation is carried out by implanting a proper low dose of B+ ions over the drain side of the transistor element forming region 21, in alignment with the gate electrode 5. Region 106 is a low dose B+ implantation region.

(5) Referring to Fig. 4(e): After removing the second resist mask 24 and removing the thin oxide film 17 by etching, an impurity block oxide layer 9 is formed on the exposed silicon surface by a heat oxidation method. Then, after forming a third resist mask 26 having an aperture 25 for exposing the drain forming region at the drain side of the transistor element forming region 21, ion implantation is carried out using a proper high dose of B+, in alignment with the gate electrode 5 and the aperture 25 in the third resist mask 26. Regions 107 and 108 thus provided are a first high B+ implantation region and second B+ implantation region respectively.

(6) Referring to Fig. 4(f): After removing the third resist mask 26 and activating the low B+ implantation region 106, the first high B+ implantation region 107 and the second high B+ implantation region 108, the following steps are carried out: a p+ type source region 7 is formed in the n+ type region 15, to a depth of 6,000 Angstroms (600 nm), by inverting the region 15 so as to have an impurity concentration of approximately $10^{20}$ cm$^{-3}$, in alignment with the gate electrode 5; a p− type offset region 6 is formed at the drain side of the transistor element forming region 21; and a p+ type drain region 8 is formed so as to have an impurity concentration of approximately $10^{20}$ cm$^{-3}$ to a depth of 6,000 Angstroms (600 nm) in alignment with the aperture 25 of the third resist mask. As will be seen this provides that a source region side edge of the channel region - see below - is aligned with an edge of the gate electrode 5.

The n+ type region 15, which stays under the gate electrode 5, functions as an enhancement type channel region 16 having a channel length $L_{ch}$ is defined by the difference between diffusion depth of the n+ type region 15 and of the p+ type source region 7. This definition is carried out by means of the DSA method. The p−− type inversion region 114 functions as p−− type depletion region 14 (see above).

(7) Referring to Fig. 2: After the above steps from (1) to (6) are completed, the following steps are carried out: an insulating film 10 comprising PSG is formed by a CVD method, and wiring contact windows for exposing respective parts of the insulating film 10, the source region 7, the gate electrode 5 and the drain region 8 are formed; and wirings made of, for example, Al are formed on the insulating film 10 so that source wiring 11, gate wiring 12 and drain wiring 13 are connected with the respective regions.

(8) Though not indicated in a Figure, an insulating film for covering the transistor element fabricated is formed. The fabrication of a MOS transistor having a high breakdown voltage characteristic is then complete.

By so arranging the depletion region and the enhancement type channel region under the gate electrode, in a direction from the drain region to the source region, the MOS transistor of this embodiment of the present invention can have a breakdown voltage as high as 100 volts.

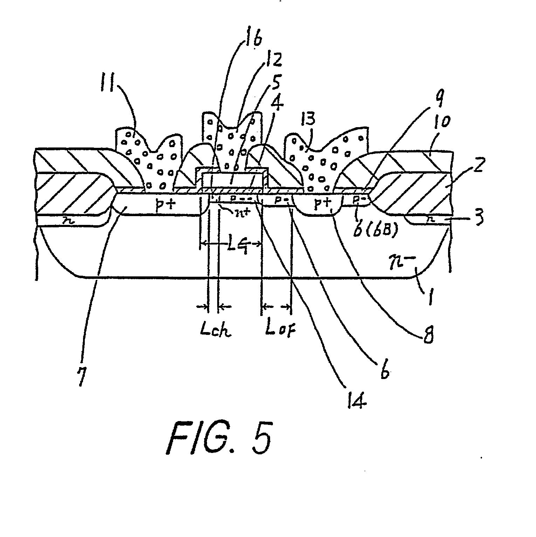

In the above fabrication method, the enhancement type channel region 16 is formed by applying a DSA method. However, channel region 16 can be fabricated by locally doping first impurities, leaving the depletion region 14 otherwise intact, as shown in Fig. 5. However, in this case, proper masks are required for the doping and it can be difficult to fabricate the extremely short channel length $L_{ch}$ with good reproducibility in view of mask alignment requirements. The DSA method mentioned above is more favourable than this doping method.

A metal insulator semiconductor device having a high breakdown voltage characteristic. The device comprises a depletion region (14) and an enhancement region (16) formed in a semiconductor substrate (1) under a gate electrode (5). The depletion region (14) is formed adjacent to an offset region (6) formed around a drain region (8). The enhancement region (16), which provides a channel region, is formed between the depletion region (14) and a source region (7) so as to have an extremely short channel length ($L_{ch}$). The enhancement type channel region (16) has a concentration of first type impurities higher than that of similar type impurities in the semiconductor substrate, and the depletion region (14) has a concentration of second type impurities, opposite to the first type, which is lower than the concentration of similar impurities in the offset region (6) for increasing breakdown voltage at the drain region (8). The short channel length ($L_{ch}$) can be formed by use of a diffusion self-aligning method.

## Claims

1. A metal insulator semiconductor device having a high breakdown voltage characteristic, comprising:

a semiconductor body having a first region (1, $L_g$) containing a first concentration of impurities of a first type;

a gate electrode (5) formed to extend over the first region (1, $L_g$);

a source region (7), formed in the body adjacent to the first region (1, $L_g$), containing a second concentration of impurities of a second type, opposite to the first type;

a drain region (8), formed in the body, containing impurities of the second conductivity type to the second concentration, the drain region (8) being formed opposite to the source region (7) with regard to the gate electrode (5) so that a side edge of the drain region, facing the source region, is separated by a first space ($L_{OF}$) from the first re-

gion (1, $L_g$); and

a first offset region (6, 6A) formed adjacent to the drain region (8) to occupy the first space ($L_{OF}$), the first offset region containing impurities of the second conductivity type to a third concentration, lower than the second concentration; characterised by at least one depletion region (14), formed in the first region (1, $L_g$) so as to be adjacent to the first offset region (6, 6A), the depletion region (14) containing impurities of the second conductivity type to a fourth impurity concentration, lower than the third impurity concentration, and a side edge of the depletion region (14), facing the source region (7), being positioned so as to be separated by a second space ($L_{ch}$) from the source region; and

an enhancement type channel region (16) formed in said first region (1, $L_g$) so as to fill up said second space ($L_{ch}$), said channel region containing impurities of the first conductivity type to a fifth impurity concentration, higher than said first impurity concentration.

2. A device as claimed in claim 1, wherein the first impurity concentration is of the order of $10^{15}$ cm$^{-3}$, the second impurity concentration is of the order of $10^{20}$ cm$^{-3}$, the third impurity concentration is of the order of $10^{17}$ cm$^{-3}$, the fourth impurity concentration is of the order of $10^{16}$ cm$^{-3}$, and the fifth impurity concentration is of the order of $10^{18}$ cm$^{-3}$.

3. A device as claimed in claim 1 or 2, wherein said second space ($L_{ch}$) has a length of 0.2 to 0.5 $\mu$m in a direction from the source region (7) to the drain region (8).

4. A method for fabricating a metal insulator semiconductor device having a high breakdown voltage characteristic comprising the steps of:

providing a first semiconductor substrate region (1) containing a first impurity concentration of impurities of a first type;

forming a fourth region (114) containing impurities of a second type, opposite to the first type, to a fourth impurity concentration, in the first region;

forming a gate electrode (5) to extend over the fourth region;

forming a fifth region (15), with impurities of the first type to a fifth impurity concentration, in the first region (1), adjacent to one side of the gate electrode (5), by doping first type impurities into the fourth region (114) in alignment with the gate electrode, the fifth impurity concentration being higher than said first impurity concentration;

inverting the conductivity type of a part of the fourth region (114) neighbouring the fifth region (15) and under the gate electrode (5), so as to have the fifth impurity concentration, by laterally diffusing the fifth region so that the fifth region extends laterally by a second length ($L_{ch}$), in direction from the said one side of the gate electrode (5) to the opposite side of the gate electrode;

forming a third region (6, 6A, 6B), having a third impurity concentration of impurities of the second type, in the first region (1) adjacent to the said opposite side of the gate electrode (5), by doping impurities of the second type into the fourth region (114), in alignment with the gate electrode (5), the third impurity concentration being higher than the fourth impurity concentration; and

forming two second regions, to provide a source region (7) and a drain region (8) respectively, having a second impurity concentration of impurities of the second type by doping impurities of the second type into the fifth region (15), in alignment with the gate electrode (5), to form the source region (7), and doping impurities of the second type into the third region (6, 6A, 6B) to form the drain region (8), the second impurity concentration being higher than the third impurity concentration, the source region (7) being formed on the said one side of said gate electrode (5) and the drain region (8) being formed on the said opposite side of the gate electrode (5) spaced apart from the gate electrode (5), an edge, facing the drain region, of the gate electrode and an edge, facing the gate electrode, of the drain region being spaced apart.

5. A method as claimed in claim 4, wherein the first impurity concentration is of the order of $10^{15}$ cm$^{-3}$, the second impurity concentration is of the order of $10^{20}$ cm$^{-3}$, the third impurity concentration is of the order of $10^{17}$ cm$^{-3}$, the fourth impurity concentration is of the order of $10^{16}$ cm$^{-3}$, and the fifth impurity concentration is of the order of $10^{18}$ cm$^{-3}$.

6. A method as claimed in claim 4 or 5, wherein the second length is 0.2 to 0.5 $\mu$m in a direction from the drain region to the source region.

**Patentansprüche**

1. Metallisolator-Halbleitervorrichtung mit einer hohen Durchbruchsspannungscharakteristik, mit:

einem Halbleiterkörper, der einen ersten Bereich (1, $L_g$) hat, der eine erste Konzentration von Verunreinigungen von einem ersten Typ enthält;

einer Gateelektrode (5), die gebildet ist, um sich über den ersten Bereich (1, $L_g$) zu erstrecken;

einem Source-Bereich (7), der in dem Körper neben dem ersten Bereich (1, $L_g$) gebildet ist, der eine zweite Konzentration von Verunreinigungen von einem zweiten Typ, entgegengesetzt zu dem ersten Typ, enthält;

einem Drainbereich (8), der in dem Körper gebildet ist, der Verunreinigungen von dem zweiten Leitfähigkeitstyp in einer zweiten Konzentration enthält, welcher Drainbereich (8) in bezug auf die Gateelektrode (5) gegenüber dem Source-Bereich (7) so gebildet ist, daß ein seitlicher Rand des Drainbereichs, welcher dem Source-Bereich zugewandt ist, durch einen ersten Raum ($L_{OF}$) von dem ersten Bereich (1, $L_g$) getrennt ist; und ein erster versetzter Bereich (6, 6A), der neben dem Drainbereich (8) gebildet ist, um den ersten Raum ($L_{OF}$) einzunehmen, wobei der erste versetzte Bereich Verunreinigungen von dem zweiten Leitfähigkeitstyp in einer dritten Konzentration enthält, die geringer als die zweite Konzentration ist;

gekennzeichnet durch wenigstens einen Verarmungsbereich (14), der in dem ersten Bereich (1, $L_g$) so gebildet ist, daß er an den ersten versetzten Bereich (6, 6A) angrenzt, welcher Verarmungsbereich (14) Verunreinigungen von dem zweiten Leitfähigkeitstyp in einer vierten Verunreinigungskonzentration enthält, die geringer als die dritte Verunreinigungskonzentration ist, und ein seitlicher Rand des Verarmungsbereichs (14), welcher dem Source-Bereich (7) zugewandt ist, so positioniert ist, daß er durch einen zweiten Raum ($L_{ch}$) von dem Source-Bereich getrennt ist; und

einen Anreicherungstyp-Kanalbereich (16), der in dem genannten ersten Bereich (1, $L_g$) gebildet ist, um so den genannten zweiten Raum ($L_{ch}$) aufzufüllen, welcher genannte Kanalbereich Verunreinigungen von dem ersten Leitfähigkeitstyp in einer fünften Verunreinigungskonzentration enthält, die höher als die genannte erste Verunreinigungskonzentration ist.

2. Vorrichtung nach Anspruch 1, bei der die erste Verunreinigungskonzentration in der Größenordnung von $10^{15}$ cm$^{-3}$, die zweite Verunreinigungskonzentration in der Größenordnung von $10^{20}$ cm$^{-3}$, die dritte Verunreinigungskonzentration in der Größenordnung von $10^{17}$ cm$^{-3}$, die vierte Verunreinigungskonzentration in der Größenordnung von $10^{16}$ cm$^{-3}$ und die fünfte Verunreinigungskonzentration in der Größenordnung von $10^{18}$ cm$^{-3}$ ist.

3. Vorrichtung nach Anspruch 1 oder 2, in der der genannte zweite Raum ($L_{ch}$) eine Länge von 0,2 bis 0,5 μm in einer Richtung von dem Source-Bereich (7) zu dem Drain-Bereich (8) hat.

4. Verfahren zur Herstellung einer Metallisolator-Halbleitervorrichtung mit einer hohen Durchbruchsspannungscharakteristik, welches die folgenden Schritte umfaßt:

Bereitstellen eines ersten Halbleitersubstratbereichs (1), der eine erste Verunreinigungskonzentration von Verunreinigungen von einem ersten Typ hat;

Bilden eines vierten Bereiches (114), der Verunreinigungen von einem zweiten Typ, entgegengesetzt zu dem ersten Typ, mit einer vierten Verunreinigungskonzentration hat, in dem ersten Bereich;

Bilden einer Gateelektrode (5), die sich über den vierten Bereich erstrecken soll;

Bilden eines fünften Bereiches (15), mit Verunreinigungen von dem ersten Typ in einer fünften Verunreinigungskonzentration, in dem ersten Bereich (1), neben einer Seite der Gateelektrode (5), durch Dotieren von Verunreinigungen von dem ersten Typ in dem vierten Bereich (114) in Ausrichtung mit der Gateelektrode, wobei die fünfte Verunreinigungskonzentration höher als die genannte erste Verunreinigungskonzentration ist;

Invertieren des Leitfähigkeitstyps von einem Teil des vierten Bereiches (114), der dem fünften Bereich benachbart und unter der Gateelektrode (5) ist, um so die fünfte Verunreinigungskonzentration zu erhalten, durch seitliche Diffusion des fünften Bereichs, so daß der fünfte Bereich sich seitlich um eine zweite Länge ($L_{ch}$) in Richtung von der genannten einen Seite der Gateelektrode (5) zu der gegenüberliegenden Seite der Gateelektrode erstreckt;

Bilden eines dritten Bereichs (6, 6A, 6B), der eine dritte Verunreinigungskonzentration von Verunreinigungen von dem zweiten Typ hat, in dem ersten Bereich (1) neben der genannten gegenüberliegenden Seite der Gateelektrode (5), durch Dotieren von Verunreinigungen von dem zweiten Typ in den vierten Bereich (114), in Ausrichtung mit der Gateelektrode (5), wobei die dritte Verunreinigungskonzentration höher als die vierte Verunreinigungskonzentration ist; und

Bilden von zwei zweiten Bereichen, um einen Source-Bereich (7) bzw. einen Drain-Bereich (8) herzustellen, welcher eine zweite Verunreinigungskonzentration von Verunreinigungen von dem zweiten Typ hat, durch Dotieren von Verunreinigungen von dem zweiten Typ in den fünften Bereich (15), in Ausrichtung mit der Gateelektrode (5), um den Source-Bereich (7) zu bilden, und Dotieren von Verunreinigungen von dem zweiten Typ in den dritten Bereich (6, 6A, 6B), um den Drain-Bereich (8) zu bilden, wobei die zweite Verunreinigungskonzentration höher als die dritte Verunreinigungskonzentration ist, Bilden des Source-Bereiches (7) auf der genannten einen Seite der genannten Gateelektrode (5) und Bilden des Drain-Bereichs (8) auf der genannten gegenüberliegenden Seite der Gateelektrode (5), mit einem Abstand von der Gateelektrode (5), wobei ein dem Drain-Bereich zugewandter Rand der Gate-Elektrode und ein der Gate-Elektrode zugewandter Rand des Drain-Bereichs einen Abstand voneinander aufweisen.

5. Verfahren nach Anspruch 4, bei dem die erste Verunreinigungskonzentration in der Größenordnung von $10^{15}$ cm$^{-3}$, die zweite Verunreinigungskonzentration in der Größenordnung von $10^{20}$ cm$^{-3}$, die dritte Verunreinigungskonzentration in der Größenordnung von $10^{17}$ cm$^{-3}$, die vierte Verunreinigungskonzentration in der Größenordnung von $10^{16}$ cm$^{-3}$ und die fünfte Verunreinigungskonzentration in der Größenordnung von $10^{18}$ cm$^{-3}$ ist.

6. Verfahren nach Anspruch 4 oder 5, bei dem die zweite Länge 0,2 bis 0,5 μm in Richtung von dem Drain-Bereich zu dem Source-Bereich beträgt.

**Revendications**

1. Un dispositif métal-isolant-semiconducteur ayant une caractéristique de tension de claquage élevée, comprenant:

un bloc de semiconducteur comportant une première région (1, $L_g$) qui contient une première concentration d'impuretés d'un premier type;

une électrode de grille (5) qui est formée de façon à s'étendre sur la première région (1, $L_g$);

une région de source (7), formée dans le bloc en position adjacente à la première région (1, $L_g$), contenant une seconde concentration d'impuretés d'un second type, opposé au premier type;

une région de drain (8), formée dans le bloc, contenant des impuretés du second type de conductivité avec la seconde concentration, la région de drain (8) étant formée du côté opposé à la région de source (7) par rapport à l'électrode de grille (5), de façon qu'un bord latéral de la région de drain, faisant face à la région de source, soit séparé par un premier espace ($L_{OF}$) de la première région (1, $L_g$); et

une première région de décalage (6, 6A) formée en position adjacente à la région de drain (8) de façon à occuper le premier espace ($L_{OF}$), la première région de décalage contenant des impuretés du second type de conductivité avec une troisième concentration, inférieure à la seconde concentration;

caractérisé par au moins une région de désertion (14), formée dans la première région (1, $L_g$), de façon à être adjacente à la première région de décalage (6, 6A), la région de désertion (14) contenant des impuretés du second type de conductivité avec une quatrième concentration d'impuretés, inférieure à la troisième concentration d'impuretés, et un bord latéral de la région de désertion (14), qui fait face à la région de source (7), étant positionné de façon à être séparé de la région de source par un second espace ($L_{ch}$); et

une région de canal du type à enrichissement (16) formée dans la première région (1, $L_g$), de façon à remplir le second espace ($L_{ch}$), cette région de canal contenant des impuretés du premier type de conductivité avec une cinquième concentration d'impuretés, supérieure à la première concentration d'impuretés.

2. Un dispositif selon la revendication 1, dans lequel la première concentration d'impuretés est de l'ordre de $10^{15}$ cm$^{-3}$, la seconde concentration d'impuretés est de l'ordre de $10^{20}$ cm$^{-3}$, la troisième concentration d'impuretés est de l'ordre de $10^{17}$ cm$^{-3}$, la quatrième concentration d'impuretés est de l'ordre de $10^{16}$ cm$^{-3}$, et la cinquième concentration d'impuretés est de l'ordre de $10^{18}$ cm$^{-3}$.

3. Un dispositif selon la revendication 1 ou 2, dans lequel le second espace ($L_{ch}$) a une longueur de 0,2 à 0,5 μm dans une direction allant de la région de source (7) vers la région de drain (8).

4. Un procédé pour fabriquer un dispositif métal-isolant-semiconducteur ayant une caractéristique de tension de claquage élevée, comprenant les opérations suivantes:

on établit une première région de substrat semiconducteur (1) contenant une première concentration d'impuretés d'un premier type;

on forme dans la première région une quatrième région (114) contenant des impuretés d'un second type, opposé au premier type, avec une quatrième concentration d'impuretés;

on forme une électrode de grille (5) de façon qu'elle s'étende sur la quatrième région;

on forme dans la première région (1) une cinquième région (15), contenant des impuretés du premier type avec une cinquième concentration d'impuretés, en position adjacente à un premier côté de l'électrode de grille (5), en introduisant des impuretés de dopage du premier type dans la quatrième région (114), en alignement avec l'électrode de grille, la cinquième concentration d'impuretés étant supérieure à la première concentration d'impuretés;

on inverse le type de conductivité d'une partie de la quatrième région (114) qui se trouve au voisinage de la cinquième région (15) et sous l'électrode de grille (5), de façon à lui donner la cinquième concentration d'impuretés, en faisant diffuser latéralement la cinquième région de façon que cette cinquième région s'étende latéralement sur une seconde longueur ($L_{ch}$), dans la direction allant du premier côté de l'électrode de grille (5) vers le côté opposé de l'électrode de grille;

on forme dans la première région (1) une troisième région (6, 6A, 6B) ayant une troisième concentration d'impuretés du second type, en position adjacente au côté opposé de l'électrode de grille (5), en introduisant des impuretés de dopage du second type dans la quatrième région (114), en alignement avec l'électrode de grille (5), la troisième concentration d'impuretés étant supérieure à la quatrième concentration d'impuretés; et

on forme deux secondes régions, pour établir respectivement une région de source (7) et une région de drain (8) ayant une seconde concentration d'impuretés du second type, en introduisant des impuretés de dopage du second type dans la cinquième région (15), en alignement avec l'électrode de grille (5), pour former la région de source (7), et en introduisant des impuretés de dopage du second type dans la troisième région (6, 6A, 6B) pour former la région de drain (8), la seconde concentration d'impuretés étant supérieure à la troisième concentration d'impuretés, la région de source (7) étant formée du premier côté de l'électrode de grille (5) et la région de drain (8) étant formée du côté opposé de l'électrode de grille (5), en étant espacée par rapport à l'électrode de grille (5), de façon qu'un bord de l'électrode de grille qui fait face à la région de drain et un bord de la région de drain qui fait face à l'électrode de grille soient mutuellement espacés.

5. Un dispositif selon la revendication 4, dans lequel la première concentration d'impuretés est de l'ordre de $10^{15}$ cm$^{-3}$, la seconde concentration d'impuretés est de l'ordre de $10^{20}$ cm$^{-3}$, la troisième concentration d'impuretés est de l'ordre de $10^{17}$ cm$^{-3}$, la quatrième concentration d'impuretés est de l'ordre de $10^{16}$ cm$^{-3}$, et la cinquième concentration d'impuretés est de l'ordre de $10^{18}$ cm$^{-3}$.

6. Un procédé selon la revendication 4 ou 5, dans lequel la seconde longueur est de 0,2 à 0,5 mm dans une direction allant de la région de drain vers la région de source.

FIG. 1

FIG. 2

FIG. 3

FIG. 4(a)

FIG. 4(b)

FIG. 4(c)

FIG. 4(d)

FIG. 4(e)

FIG. 4(f)

FIG. 5